# EUROPÄISCHE PATENTSCHRIFT

(11) **EP 1 913 408 B1**
(45) Veröffentlichungstag und Bekanntmachung des Hinweises auf die Patenterteilung: **26.12.2018**
(21) Anmeldenummer: 06762087.2
(22) Anmeldetag: 19.06.2006
(51) Int. Cl.: G01R 27/32

(54) **MESSVORRICHTUNG, INSBESONDERE VEKTORIELLER NETZWERKANALYSATOR, MIT PHASENREGELUNG**
MEASURING DEVICE, PARTICULARLY A VECTORIAL NETWORK ANALYZER WITH PHASE-SHIFT CONTROL
DISPOSITIF DE MESURE, EN PARTICULIER ANALYSEUR DE RESEAU VECTORIEL, A DECALAGE DE PHASE

(30) Priorität: 08.08.2005 DE 102005037353
(43) Veröffentlichungstag der Anmeldung: 23.04.2008
(73) Patentinhaber: Rohde & Schwarz GmbH & Co. KG, 81671 München (DE)
(72) Erfinder: EVERS, Christian, 85551 Kirchheim (DE); BEDNORZ, Thilo, 85435 Erding (DE); ORTLER, Georg, 86459 Gessertshausen (DE)
(74) Vertreter: Körfer, Thomas
(86) Internationale Anmeldenummer: PCT/EP2006/005865
(87) Internationale Veröffentlichungsnummer: WO 2007/017001

(56) Entgegenhaltungen:
- DE-A1- 10 246 700
- DE-A1- 10 331 092
- US-A1- 2004 196 051

## Beschreibung

Die Erfindung betrifft eine Messvorrichtung, insbesondere einen vektoriellen Netzwerkanalysator.

Insbesondere bei der Netzwerkanalyse, aber auch bei anderen Messproblemen, muss ein zu vermessendes Bauteil (DUT = Device Under Test) mit einem differentiellen Signal im sog. "differential mode" angeregt werden, wie es zum Beispiel in der DE 102 46 700 A1 zu sehen ist. Beim "differential mode" (differentielle Betriebsart) besteht zwischen den beiden Anregungssignalen eine feste Phasendifferenz von 180°. Beim sog. "common mode" hingegen müssen die beiden Tore des Prüflings mit einem genau gleichphasigen Anregungssignal beaufschlagt werden. Auch andere feste Phasenbeziehungen zwischen den Anregungssignalen als 180° und 0° sind denkbar und kommen in der Praxis vor. Das Messproblem besteht also allgemein darin, zwei Anregungssignale zu erzeugen, die genau die gleiche Frequenz und eine feste, nicht fluktuierende Phasendifferenz zueinander haben.

Um eine Signalquelle für den "differential mode" zu erhalten wird in der US 2004/0196051 A1 vorgeschlagen, einen gemeinsamen Synthesizer für die beiden Anregungs-Tore zu verwenden und die zwischen den beiden Toren auftretenden Phasenunterschiede durch Regelsignale auszugleichen, die zwei Vektormodulatoren zugeführt werden, welche sich unmittelbar an den Ausgängen der Signalquelle befinden. Die Vektormodulatoren sind jedoch relativ teure Bauteile, so dass diese Vorgehensweise relativ aufwendig ist.

Der Erfindung liegt daher die Aufgabe zugrunde, eine Messvorrichtung und ein entsprechendes Betriebsverfahren für diese Messvorrichtung vorzuschlagen, welches mit nur geringem Aufwand zwei Anregungssignale mit einer festen, nur wenig fluktuierenden Phasendifferenz zur Verfügung gestellt. Die Aufgabe wird bezüglich des Messgeräts durch die Merkmale des Anspruchs 1 und bezüglich des Verfahrens zum Betreiben des Messgeräts durch die Merkmale des Anspruchs 7 gelöst. Die Unteransprüche enthalten vorteilhafte Weiterbildungen der Erfindung.

Erfindungsgemäß wird vorgeschlagen, für die beiden Toren, an welchen Anregungssignale mit der gleichen Frequenz und einer festen, nicht fluktuierenden Phasenbeziehung erzeugt werden sollen, jeweils einen separaten Signalgenerator vorzusehen, die mit unterschiedlicher Frequenz betrieben werden können. Der Ist-Phasenversatz wird an zwei internen Messstellen des Messgeräts, beispielsweise des Netzwerkanalysators, gemessen. Bei einer Abweichung von dem Soll-Phasenversatz wird die Frequenz eines oder beider Signalgeneratoren während eines Korrekturzeitintervalls so verändert, dass der vorgegebene Soll-Phasenversatz wieder erreicht wird.

Dies kann dadurch erreicht werden, dass entweder die Frequenz des bezüglich der Phase nachlaufenden Signalgenerators während des Korrekturzeitintervalls erhöht wird oder indem die Frequenz des anderen, bezüglich der Phase vorlaufenden Signalgenerators während des Korrekturzeitintervalls erniedrigt wird. Es können auch beide Maßnahmen miteinander kombiniert werden.

In der meßtechnischen Praxis kommt es darauf an, dass die Phasenbeziehung zwischen den Anregungssignalen an bestimmten Referenzstellen, die in ihrer Gesamtheit auch als Referenzebene bezeichnet werden, eingehalten wird. Bei der Referenzebene handelt es sich typischerweise um das prüflingseitige Ende der Steckerverbindung des Messkabels. Tatsächlich gemessen wird der Phasenversatz zwischen den Anregungssignalen aber an internen Messstellen des Messgeräts, beispielsweise des Netzwerkanalysators. Die Laufzeit der Welle von der internen Messstelle des Messgeräts zu der externen Referenzstelle, beispielsweise am Ende des Messkabels, ist für beide mit dem Anregungssignal beaufschlagten Tore beispielsweise aufgrund unterschiedlicher Länge der Messkabel im allgemeinen nicht exakt gleich, so dass ein bestimmter Soll-Phasenversatz zwischen den Anregungssignalen an den Referenzstellen einem anderen Soll-Phasenversatz an den Messstellen entspricht. Die Zuordnung ist aber eindeutig und kann durch ein im einzelnen noch zu erläuterndes Kalibrierverfahren für jede Betriebsfrequenz gesondert bestimmt und in einer Tabelle gespeichert werden. Soll beim späteren Betrieb ein bestimmter Soll-Phasenversatz zwischen den Referenzstellen erreicht werden, so ist durch die Tabelle bekannt, welcher Soll-Phasenversatz hierfür zwischen den Messstellen eingehalten werden muss. Der Ist-Phasenverstz an den Messstellen kann dann gemessen werden und mit dem Soll-Phasenversatz an den Messstellen verglichen werden. Bei einer positiven Abweichung kann dann entweder die Frequenz des vorauseilenden Signalgenerators erniedrigt und/oder die Frequenz des nacheilenden Signalgenerators erhöht werden. Bei einer negativen Abweichung wird umgekehrt vorgegangen.

Das Erstellen der Kalibrier-Tabelle kann für den "differential mode", also für einen angestrebten Phasenversatz von 180°, mit einem Mehrtor-Netzwerkanalysator in einfacher Weise dadurch erfolgen, dass die Anregungssignale an der Referenzebene mittels eines Signalkombinierers addiert werden und das Summensignal einem dritten Tor des Netzwerkanalysators zugeführt wird, welcher die Amplitude des Summensignals mißt. Bei einer Phasendifferenz von 180° tritt ein Minimum der Amplitude des Summensignals auf und das Summensignal wird komplett ausgelöscht, wenn auch die Amplituden der beiden Anregungssignale gleich sind. Auf diese Weise können auch die Amplituden der Anregungssignale kalibriert werden.

Die Erfindung wird nachfolgend unter Bezugnahme auf die Zeichnung anhand eines Ausführungsbeispiels beschrieben. In der Zeichnung zeigen:
- Fig. 1: ein Anwendungsbeispiel der erfindungsgemäßen Messvorrichtung zur Messung eines Prüflings im "differential mode";
- Fig. 2: eine erste Konfiguration zur Kalibrierung der erfindungsgemäßen Messvorrichtung;
- Fig. 3: ein detailliertes Ausführungsbeispiel eines Netzwerkanalysators in der in Fig. 2 gezeigten Konfiguration zur Kalibrierung;
- Fig. 4: ein Diagramm zur Erläuterung der Betriebsweise der erfindungsgemäßen Messvorrichtung und
- Fig. 5: die erfindungsgemäße Messvorrichtung in einer zweiten Konfiguration zur Kalibrierung.

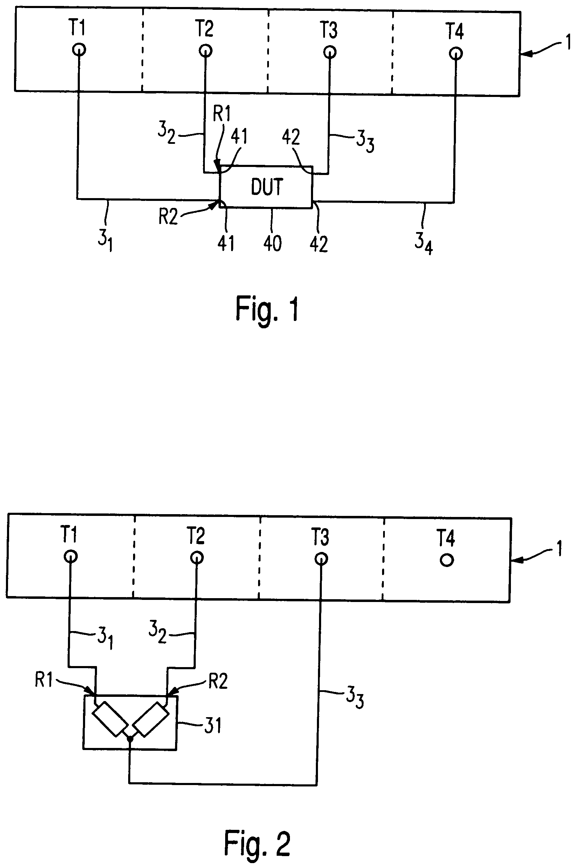

Fig. 1 zeigt eine Messvorrichtung 1 beispielsweise in Form eines vektoriellen Mehrtor-Netzwerkanalysators mit im Ausführungsbeispiel vier Toren T1 bis T4. Im in Fig. 1 dargestellten Messbeispiel wird ein viertoriger Prüfling (DUT) 40 vermessen, der zwei Eingangstore 41 und zwei Ausgangstore 42 hat. Bei dem Prüfling handelt es sich beispielsweise um einen Verstärker, der ein differentielles Eingangssignal in ein differentielles Ausgangssignal verstärkt. Zur exakten Vermessung des Prüflings ist es daher erforderlich, an die aus zwei Referenzstellen R1 und R2 bestehende Referenzebene ein differentielles Anregungssignal anzulegen, welches aus zwei über die Tore T1 und T2 zugeführten Anregungsteilsignalen besteht, die zueinander an den Referenzstellen R1 und R2 einen Phasenversatz von exakt 180° haben. Der Netzwerkanalysator misst die von dem Prüfling reflektierten und die durch den Prüfling transmittierten Wellen bei unterschiedlichen Frequenzen. Deshalb muss der Phasenversatz von 180° an den Referenzstellen R1 und R2 nicht nur bei einer Frequenz sondern bei sämtlichen Betriebsfrequenzen des Netzwerkanalysators 1 eingehalten werden. Um dies zu gewährleisten, muss eine nachfolgend zu beschreibende Kalibrierung durchgeführt werden.

Fig. 2 zeigt eine erste Konfiguration zur Kalibrierung des Netzwerkanalysators 1. Hierbei werden die Anregungssignale an den Referenzstellen R1 und R2, die über die Messkabel 3₁ und 3₂ mit den Toren T1 und T2 verbunden sind, an einem Signalkombinierer 31, vorzugsweise einem resistiven Signalkombinierer, zu einem Summensignal kombiniert, welches dem dritten Tor T3 des Netzwerkanalysators 1 zugeführt wird.

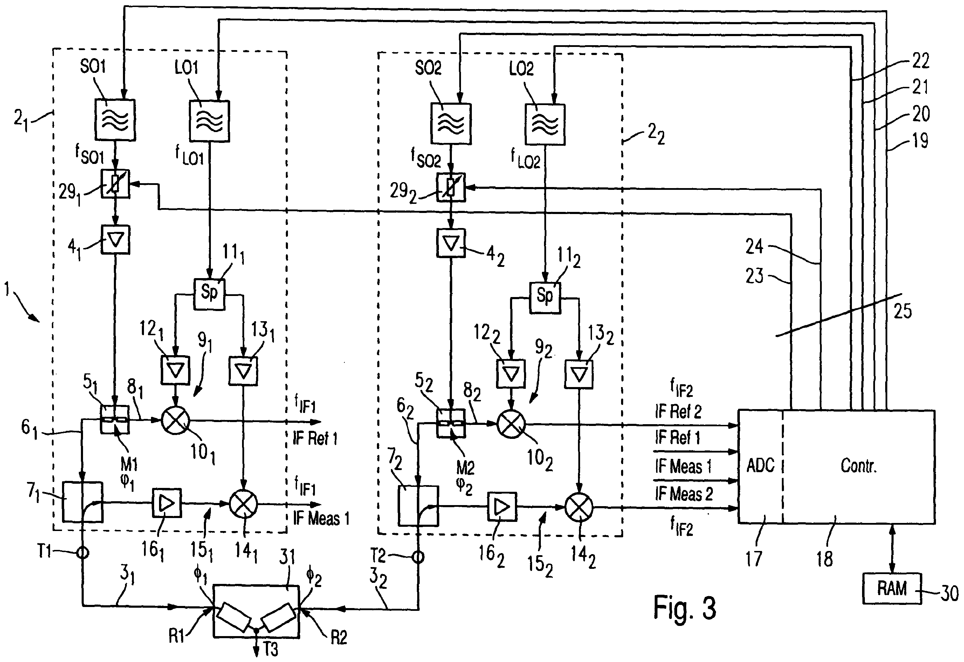

Fig. 3 zeigt den internen Aufbau des Netzwerkanalysators 1, wobei nur die Anregungs-/Empfangseinheiten 2₁ und 2₂ der beiden Tore T1 und T2 dargestellt sind. Für die Tore T3 und T4 sind entsprechende Anregungs-/Empfangseinheiten vorhanden.

Beim in Fig. 3 dargestellten Ausführungsbeispiel ist an jedem T or T1, T2, T3 und T4 der Messvorrichtung 1 eine separate Anregungs-/Empfangseinheit 2₁ bzw. 2₂ vorhanden. Jede Anregungs-/Empfangseinheit 2₁ bzw. 2₂ verfügt über einen separaten Signalgenerator SO1 bzw. SO2, mit welchem das Messobjekt DUT mit einem Anregungssignal beaufschlagbar ist.

Jedes der beiden differentiellen Eingangstore des Messobjekts DUT ist im in Fig. 1 dargestellten Messbeispiel über eine Messleitung 3₁ bzw. 3₂ mit einem der beiden Tore T1 bzw. T2 der Messvorrichtung 1 verbunden, während jedes der beiden differentiellen Ausgangstore 42 des Messobjekts DUT über eine Messleitung 3₃ und 3₄ mit einem der beiden Tore T3 bzw. T4 der Messvorrichtung 1 verbunden ist. In Fig. 3 ist nicht die Messkonfiguration, sondern die Kalibrierkonfiguration der Fig. 2 dargestellt. Trotzdem bezieht sich nachfolgende Beschreibung auch auf die Messkonfiguration mit dem Prüfling DUT.

Die Signalgeneratoren SO1 und SO2 sind jeweils über ein variables Dämpfungsglied 29₁ bzw. 29₂ und jeweils einen Verstärker 4₁ bzw. 4₂ mit einem Signal-Teiler (signal splitter) 5₁ bzw. 5₂ verbunden. Ein Signalzweig 6₁ bzw. 6₂ steht jeweils über einen Richtkoppler 7₁ bzw. 7₂ mit dem zugeordneten Tor T1 bzw. T2 in Verbindung. Der andere Zweig 8₁ bzw. 8₂ ist mit einem Mischer 10₁ bzw. 10₂ einer ersten Empfangseinrichtung 9₁ bzw. 9₂ der jeweiligen Anregungs-/Empfangseinheit 2₁ bzw. 2₂ verbunden. Die erste Empfangseinrichtung 9₁ bzw. 9₂ empfängt somit, wenn der zugehörige Signalgenerator SO1 bzw. SO2 aktiv ist, das Anregungssignal. Ferner wird dem Mischer 10₁ bzw. 10₂ ein Oszillatorsignal zugeführt, das im Ausführungsbeispiel von einem internen Oszillator LO1 bzw. LO2 der jeweiligen Anregungs-/Empfangseinheit 2₁ bzw. 2₂ erzeugt wird und dem Mischer 10₁ bzw. 10₂ über einen Signal-Teiler (signal splitter) 11₁ und 11₂ und jeweils einen Verstärker 12₁ bzw. 12₂ zugeführt wird.

Im Ausführungsbeispiel versorgt der gleiche Oszillator LO1 bzw. LO2 über den anderen Signalzweig der Signal-Teiler 11₁ bzw. 11₂ und einen entsprechenden Verstärker 13₁ bzw. 13₂ einen Mischer 14₁ bzw. 14₂ einer zweiten Empfangseinrichtung 15₁ bzw. 15₂ der jeweiligen Anregungs-/Empfangseinheit 2₁ bzw. 2₂. Der Mischer 14₁ bzw. 14₂ steht über einen Isolations-Verstärker 16₁ bzw. 16₂ und den Richtkoppler 7₁ bzw. 7₂ mit dem zugeordneten Tor T1 bzw. T2 in Verbindung. Somit erhält die zweite Empfangseinrichtung 15₁ das von dem zugehörigen Tor T1 empfangene, von dem Messobjekt zum Tor T1 reflektierte oder durch das Messobjekt DUT von dem Tor T1 zum Tor T2 transmittierte Signal. Entsprechend empfängt die zweite Empfangseinrichtung 15₂ der Anregungs-/Empfangseinheit 2₂ das von dem Messobjekt DUT zum Tor T2 reflektierte oder durch das Messobjekt DUT vom Tor T1 zum Tor T2 transmittierte Signal. Die Mischer 10₁ und 14₁ der ersten Anregungs-/Empfangseinheit 2₁ setzen das empfangene Signal in eine erste Zwischenfrequenzlage mit der Zwischenfrequenz f_{IF1} um, während die Mischer 10₂ und 14₂ der zweiten Anregungs-/Empfangseinheit 2₂ das empfangene Signal in eine zweite Zwischenfrequenzlage mit der Zwischenfrequenz f_{IF2} umsetzen. Dabei sind die Zwischenfrequenzen f_{IF1} und f_{IF2} nicht notwendigerweise identisch.

Das von den Mischern 10₁ bzw. 10₂ erzeugte Zwischenfrequenz-Referenzsignal IF Ref 1 bzw. IF Ref 2 sowie das von den Mischern 14₁ bzw. 14₂ erzeugte Zwischenfrequenz-Messsignal IF Meas 1 bzw. IF Meas 2 wird einem Analog/Digital-Wandler 17 zugeführt, welcher mit einer Signalauswertungs- und Steuereinheit 18 in Verbindung steht. In dieser erfolgt eine Auswertung der Referenzsignale und der Messsignale. Die Signalauswertungs- und Steuereinheit 18 steuert ferner über Steuerleitungen 19, 20, 21 und 22 die Signalgeneratoren SO1 und SO2 sowie die Oszillatoren LO1 und LO2 so an, dass diese ein Signal mit vorbestimmter Frequenz f_{SO1}, f_{LO1}, f_{SO2} bzw. f_{LO2} erzeugen.

Über weitere Steuerleitungen 23 und 24 steht die Auswerte- und Steuereinheit 18 mit den einstellbaren Dämpfungsgliedern 29₁ und 29₂ in Verbindung, so dass die Signalamplitude des von den Signalgeneratoren SO1 und SO2 erzeugten Anregungssignals steuerbar ist. Da die Ist-Amplitude des Anregungssignals über die Zwischenfrequenz-Referenzsignale IF Ref 1 und IF Ref 2 erfaßt werden, kann auf diese Weise eine Regelschleife zur exakten Regelung der Anregungsamplitude gebildet werden.

Die Steuerleitungen 19 bis 23 können zu einem Bus-System 25, insbesondere einem LAN-Bus-System, zusammengefaßt werden.

Es sei nochmals betont, dass die erfindungsgemäße Weiterbildung sich nicht nur auf einen Netzwerkanalysator bezieht wie er in Fig. 3 dargestellt ist, sondern auch in anderen Messvorrichtungen sinnvoll ist.

Bei dem "differential mode" kommt es darauf an, dass am Ende der Messkabel 3₁ und 3₂, also an den Referenzstellen R1 und R2 ein definierter Phasenversatz von Δ*φ*=*φ*₁-*φ*₂=180° eingehalten wird. Bei anderen Anwendungen muss ein anderer Phasenversatz eingehalten werden. Beispielsweise muss beim "common mode" Gleichphasigkeit sichergestellt werden (Δ*φ*=0°). Gemessen wird die Phasendifferenz aber an den Messstellen M1 und M2 im Inneren des Netzwerkanalysators, beispielsweise an den Signalteilern 5₁ und 5₂. Die dort gemessenen Phasen sind in Fig. 3 mit *ϕ*₁ und *ϕ*₂ bezeichnet, so dass dort eine Ist-Phasendifferenz von Δ*ϕ*ᵢₛₜ gemessen wird.

Aufgrund unterschiedlicher Ausbreitungsgeschwindigkeiten der Welle in den Messkabeln 3₁ und 3₂, beispielsweise aufgrund einer nicht exakt gleichen Länge der Messkabel, unterschiedlicher Dielektrizitätskonstanten in dem Messkabel, aber auch aufgrund durch Fertigungsschwankungen hervorgerufene geringfügig unterschiedliche Laufzeiten der Wellen innerhalb der beiden Anregungs-/Empfangseinheiten 2₁ und 2₂, ist an den Messstellen M1 und M2 eine von der Soll-Phasendifferenz Δ*φ* zwischen den Referenzstellen R1 und R2 abweichende Soll-Phasendifferenz *Δϕ*=*ϕ*₁*-ϕ*₂ gegeben. Es muss also eine bestimmte Phasendifferenz Δ*ϕ* zwischen den Messstellen M1 und M2 vorgehalten werden, um an den Referenzstellen R1 und R2 die gewünschte Phasendifferenz Δ*φ* zu erzeugen. Dieser Bezug zwischen Soll-Phasendifferenz Δ*φ* an den Referenzstellen R1 und R2 und der zugehörigen Soll-Phasendifferenz *Δϕ* an den Messstellen M1 und M2 kann durch Kalibrierung ermittelt werden und in einem Speicher 30 abgelegt werden.

Dabei genügt es nicht, die Soll-Phasendifferenz Δ*ϕ* an den Messstellen M1 und M2 nur für eine Frequenz zu kalibrieren, sondern die Abweichung zwischen der Soll-Phasendifferenz Δ*ϕ* an den Messstellen M1 und M2 von der Soll-Phasendifferenz Δ*φ* an den Referenzstellen R1 und R2 ist aufgrund der Dispersion beispielsweise der Messkabel 3₁ und 3₂ frequenzabhängig. Die Kalibrierung muss daher für eine Vielzahl von Frequenzwerten, idealerweise für jeden Frequenzpunkt, der durch den Netzwerkanalysator ansteuerbar ist, durchgeführt und das Ergebnis in der im Speicher 30 gespeicherten Tabelle tabelliert werden.

Die Kalibrierung kann in der in Fig. 2 und Fig. 3 dargestellten Weise vorgenommen werden, wenn es sich bei dem Messgerät 1 um einen Netzwerkanalysator handelt. Hierzu sind die beiden Messkabel 3₁ und 3₂ des ersten Tors T1 und des zweiten Tors T2 über einen vorzugsweise resistiven Koppler 31 mit einem dritten Messkabel 3₃ verbunden, welches mit einem dritten Tor T3 des Netzwerkanalysators verbunden ist. An dem dritten Tor T3 wird die Amplitude des Summensignals, welches durch Summierung der Anregungssignale an den Referenzstellen R1 und R2 entsteht, gemessen. Sind die Amplituden der beiden Anregungssignale der Tore T1 und T2 identisch, so tritt bei einer exakten Gegenphasigkeit, d.h. bei einem Phasenversatz von exakt 180°, eine vollständige Auslöschung des Summensignals auf. Sind die Amplituden nicht gleich groß, so tritt bei der Gegenphasigkeit von 180° zumindest ein deutliches Minimum auf. Wird an dem dritten Tor T3 die Amplitude des Summensignals detektiert, so kann unschwer festgestellt werden, wann exakte Gegenphasigkeit vorliegt.

Soll an den Referenzstellen R1 und R2 ein anderer Phasensatz als 180° eingestellt werden, so muss an den Messstellen M1 und M2 ein um das gleiche Maß abweichender Phasenversatz vorgehalten werden. Ist beispielsweise zur Erzielung einer 180°-Gegenphasigkeit an den Referenzstellen R1 und R2 ein Phasenversatz von 182° zwischen den Messstellen M1 und M2 erforderlich, so muss ein Phasenversatz von 2° zwischen den Messstellen M1 und M2 vorgehalten werden, um zwischen den Referenzstellen R1 und R2 Gleichphasigkeit, d.h. einen Phasenversatz von 0°, zu erzielen. Die für die Gegenphasigkeit kalibrierten Werte können daher auch auf andere Phasenversatz-Vorgaben übertragen werden.

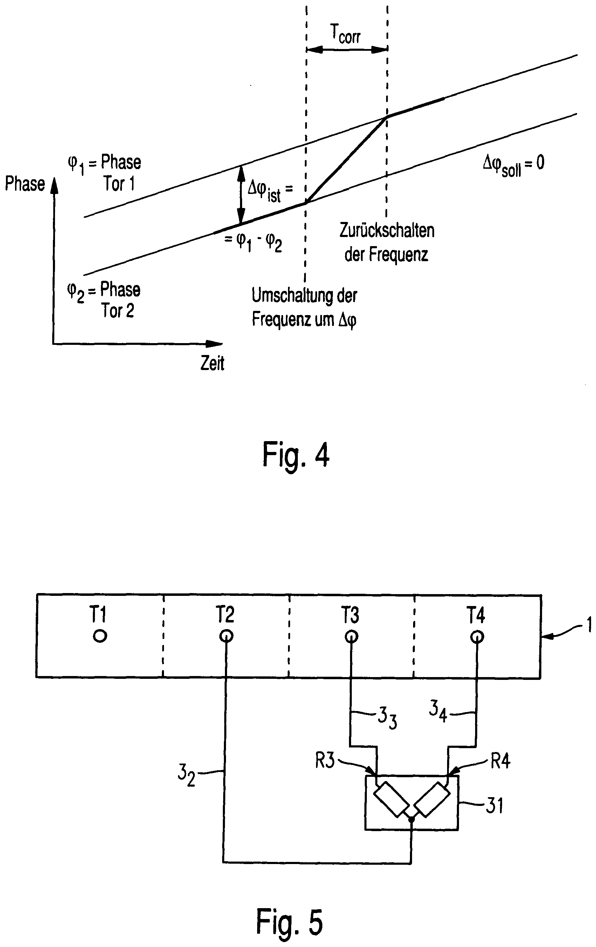

Abweichend vom Stand der Technik, wo zur Erzeugung der Anregungssignale des "differential mode" an den Toren T1 und T2 ein gemeinsamer Synthesizer und zur Erzielung des Phasenversatzes an jedem Tor ein Vektor-Modulator eingesetzt wird, ist erfindungsgemäß jede Anregungs-/ und Empfangseinheit 2₁ und 2₂ mit einem eigenen Anregungs-Oszillator SO1 und SO2 ausgestattet, die bezüglich ihrer Frequenz unabhängig eingestellt werden können. Auf den Vektor-Modulator oder ein anderes einstellbares Phasenschieberglied kann dann verzichtet werden, wenn erfindungsgemäß, wie in Fig. 4 illustriert und nachfolgend beschrieben, vorgegangen wird:
Bei den Signalgeneratoren SO1 und SO2 handelt es sich vorzugsweise um hochgenaue Synthesizer unter Verwendung von YIG-Oszillatoren, die für die Betriebsart des "differential mode" oder "common mode" zwei hochgenau gleiche Frequenzen generieren. Unter Umständen läßt sich zwar eine Soll-Phasenlage voreinstellen. Jedoch ist die aktuelle Phasenlage aufgrund der Phasenregelung in der Phasen-Regelschleife (PLL) ständig Fluktuationen unterworfen, so dass die vorgewählte Phasendifferenz ohne die erfindungsgemäße Maßnahme nicht dauerhaft eingehalten werden könnte. Erfindungsgemäß wird der Ist-Phasenversatz zwischen den Messstellen M1 und M2 mittels der Empfangseinrichtungen 9₁ und 9₂, die zusammen mit dem Analog/Digital-Wandler 17 als Phasen-Messeinrichtung dienen, ständig gemessen. In der Steuereinrichtung 18 wird der so ermittelte Ist-Phasenversatz Δ*ϕᵢₛₜ* an den Messstellen M1 und M2 mit dem in dem Speicher 30 für die aktuelle Betriebsfrequenz abgespeicherten Soll-Phasenversatz Δ*ϕₛₒₗₗ,* an den Messstellen M1 und M2, welcher zur Erzielung eines bestimmten Soll-Phasenversatzes Δ*φ* an den Referenzstellen R1 und R2 dient, verglichen.

Zeigt sich, dass der gemessene Ist-Phasenversatz Δ*ϕᵢₛₜ,* größer ist als der tabellierte Soll-Phasenversatz Δ*ϕₛₒₗₗ,* an den Messstellen M1 und M2, so wird wie folgt vorgegangen: Entweder wird die Frequenz des vorauseilenden Oszillators, beispielsweise des Oszillators SO1, während eines Korrekturzeitintervalls T_{corr} kurzzeitig erniedrigt oder die Frequenz des nacheilenden Signalgenerators, beispielsweise des Signalgenerators SO2, wird während des Korrekturzeitintervalls T_{corr} erhöht, so dass nach dem Korrekturzeitintervall T_{corr} wieder der vorgegebene Soll-Phasenversatz zwischen den Messstellen M1 und M2 erreicht wird (Δ*ϕᵢₛₜ* = Δ*ϕₛₒₗₗ*). Vor und nach dem Korrekturzeitintervall werden die beiden Signalgeneratoren SO1 und SO2 mit exakt der gleichen Frequenz betrieben. Die definierte Abweichung der beiden Frequenzen erfolgt ausschließlich während des Korrekturintervalls T_{corr}. Selbstverständlich können beide Maßnahmen, also die Erhöhung der Frequenz des nacheilenden Signalgenerators als auch die Verringerung der Frequenz des vorauseilenden Signalgenerators miteinander kombiniert werden, um die Korrekturgeschwindigkeit zu erhöhen.

Ist der gemessene Ist-Phasenversatz Δ*ϕᵢₛₜ* kleiner als der in der Tabelle des Speichers 30 gespeicherte Soll-Phasenversatz Δ*ϕₛₒₗₗ* zwischen den Messstellen M1 und M2, so wird umgekehrt vorgegangen, d.h. es wird die Frequenz des vorauseilenden Signalgenerators während des Korrekturzeitintervalls erhöht und/oder die Frequenz des nacheilenden Signalgenerators während des Korrekturzeitintervalls verringert.

Die vorstehend beschriebene Vorgehensweise ist in Fig. 4 illustriert, wobei bei diesem Beispiel zur Erhöhung der Anschaulichkeit vorausgesetzt wurde, dass der geforderte Soll-Phasenversatz Δ*ϕₛₒₗₗ* zwischen den Messstellen M1 und M2 0° beträgt. Die Darstellung zeigt, dass vor Prüfung der Phasenkorrektur während des Zeitkorrekturintervalls T_{corr} eine Abweichung des gemessenen Ist-Phasenversatzes Δ*ϕᵢₛₜ* von dem geforderten Soll-Phasenversatz Δ*ϕₛₒₗₗ*=0° vorliegt. Das heißt, obwohl gefordert wird, dass keine Phasenabweichung an den Messstellen M1 und M2 vorliegt, ist die an der Messstelle gemessene Phase *ϕ*₁ des Signalgenerators SO1 etwas größer als die an der Messstelle M2 gemessene Phase *ϕ*₂ des Signalgenerators SO2.

Nachdem die Steuereinheit 18 dies festgestellt hat, erhöht sie während des Zeitkorrekturintervalls T_{corr} in dem in Fig. 4 illustrierten Beispiel kurzzeitig die Frequenz f_{SO2} des Signalgenerators SO2. Dadurch wird die Phase des nacheilenden Signalgenerators SO2 kontinuierlich erhöht, bis am Ende des Zeitkorrekturintervalls T_{corr} wieder Gleichphasigkeit erreicht ist. Wird durch die Phasen-Messeinrichtung 9₁, 9₂, 17 diese Gleichphasigkeit gemessen, so beendet die Steuereinheit 18 die Frequenzerhöhung des Signalgenerators SO2, so dass beide Signalgeneratoren SO1 und SO2 wieder auf exakt der gleichen Frequenz betrieben werden. Die Phasenabweichung wird weiterhin überwacht. Tritt wieder eine Phasenabweichung auf, die größer ist als ein vorgegebener Schwellwert, so wird die vorstehend beschriebene Regelung erneut vorgenommen.

Hinsichtlich des Maßes der Frequenzerhöhung während des Zeitkorrekturintervalls T_{corr} muss ein Kompromiss zwischen einer schnellen Korrekturzeit und einer hohen Einstellgenauigkeit erzielt werden. Hierbei kann auch stufenweise vorgegangen werden, d.h. bei großen Phasenabweichungen wird zunächst eine große Frequenzabweichung geschaltet, die dann stufenweise verringert wird, je weiter sich der gemessene Ist-Phasenversatz Δ*ϕᵢₛₜ* an den geforderten Soll-Phasenversatz Δ*ϕₛₒₗₗ* annähert. Auch ist ein iteratives Vorgehen denkbar, d.h. es wird während eines ersten Zeitkorrekturintervalls eine Grobkorrektur vorgenommen, und dann die noch verbleibende Differenz zwischen dem dann erneut gemessenen Ist-Phasenversatz und dem geforderten Soll-Phasenversatz in einer nachfolgenden Feinkorrektur, bei der eine kleinere Frequenzabweichung zwischen den Signalgeneratoren gewählt wird, nachjustiert. Dabei kann natürlich auch in mehr als zwei Iterationsstufen vorgegangen werden.

Nachdem das erste differentielle Tor-Paar, bestehend aus den Toren T1 und T2, kalibriert wurde, müssen noch die anderen differentiellen Tor-Paare des Netzwerkanalysators in gleicher Weise kalibriert werden. Für das zweite differentielle Tor-Paar, bestehend aus den Toren T3 und T4, ist dies in Fig. 5 dargestellt. Analog zu Fig. 2 werden nun die Tore T3 und T4 jeweils über ein Messkabel 3₃ und 3₄ mit dem Signalkombinierer 31 verbunden, der das Summensignal der Anregungssignale der Tore T3 und T4 erzeugt und über das Messkabel 3₂ beispielsweise dem zweiten Tor T2 des Netzwerkanalysators zuführt. Die Gegenphasigkeit der von den Toren T3 und T4 an den Referenzstellen R3 und R4 erzeugten Signale liegt auch hier bei Erreichen eines Minimums der Amplitude des Summensignals oder einem Auslöschen des Summensignals vor. Nachdem alle differentiellen Tor-Paare, im Ausführungsbeispiel T1 und T2 einerseits und T3 und T4 andererseits, kalibriert sind, kann das erste differentielle Tor-Paar T1 und T2 mit den Eingangstoren 41 des Messobjekts (DUT) 40 verbunden werden und das andere Tor-Paar T3 und T4 kann mit den Ausgangstoren 42 des Messobjekts, wie in Fig. 1 gezeigt, verbunden werden und die Vermessung des Messobjekts kann begonnen werden.

Die Erfindung ist nicht auf das dargestellte Ausführungsbeispiel beschränkt. Beispielsweise kann die Kalibrierung auch in anderer Weise, beispielsweise durch eine Leistungsmessung, vorgenommen werden, wobei sich an dem summierten Signal bei Erreichen der Gegenphasigkeit ein Leistungsminimum einstellt. Es ist außerdem vorteilhaft, bei der Kalibrierung auch die Amplituden aneinander anzugleichen, indem nach Erreichen der Gegenphasigkeit die Amplitude eines der beiden Anregungssignale z.B. durch Ansteuern des einstellbaren Dämpfungsgliedes 29₁ oder 29₂ so lange verändert wird, bis die Auslöschung des Summensignals eintritt.

Die Erfindung ist auch nicht nur für verschiedene Mode-Einstellungsmöglichkeiten zwischen zwei Messtoren, sondern natürlich auch zwischen allen Messtoren eines beliebigen Mehrkanalsystems für beliebig anliegende Stimulisignale nutzbar, insbesondere bei Messungen an Phased-Array-Modulen, bei denen es nicht unbedingt auf eine Erregung mit symmetrischen Signalen, sondern auf die Bündelung bzw. Wechselwirkungen für bestimmte Amplituden- und Phasenbeziehungen ankommt.

## Patentansprüche

1. Messgerät (1), insbesondere vektorieller Netzwerkanalysator, das über zumindest zwei Tore (T1, T2) mit einem Messobjekt (DUT) verbindbar ist, mit
mehreren jeweils einem Tor (T1; T2) zugeordneten Anregungseinheiten (2₁; 2₂), wobei jede Anregungseinheit (2₁; 2₂) einen Signalgenerator (SO1; SO2) aufweist, mit welchem das zugeordnete Tor (T1; T2) mit einem Anregungssignal beaufschlagbar ist,
einer Phasen-Messeinrichtung (9₁, 9₂, 17) zur Messung des Ist-Phasenversatzes zwischen den an den Toren (T1; T2) ausgegebenen Anregungssignalen an Messstellen (M1, M2) und einer Steuereinrichtung (18), welche die Frequenz (f_{SO1}; f_{SO2}) zumindest eines der beiden Signalgeneratoren (SO1; SO2) während eines Korrekturzeitintervalls (T_{corr}) so verändert, dass ein vorgegebener Soll-Phasenversatz an Referenzstellen (R1, R2) zwischen den an den Toren (T1, T2) ausgegebenen Anregungssignalen erzielt wird,
**dadurch gekennzeichnet dass**
ein Bezug zwischen einer Soll-Phasendifferenz (Δ*ϕ*) an den Referenzstellen (R1, R2) und einer zugehörigen Soll-Phasendifferenz (Δ*ϕ*) an den Messstellen (M1, M2) durch Kalibrierung ermittelt ist,
wobei die Kalibrierung für jeden Frequenzpunkt, der durch das Messgerät (1) ansteuerbar ist, durchgeführt wird, und wobei die Referenzstellen (R1, R2) über Messkabel (3₁, 3₂) mit Toren des Messgeräts (1) verbunden sind.

2. Messgerät nach Anspruch 1,
**gekennzeichnet durch**
eine Speichereinrichtung (30), in welcher eine Tabelle mit jeweils einem Soll-Phasenversatz an den Messstellen in Bezug zu einem Soll-Phasenversatz an den Referenzstellen (R1, R2) zwischen den an den Toren (T1, T2) ausgegebenen Anregungssignalen jeweils für mehrere Frequenzen gespeichert ist.

3. Messgerät nach Anspruch 2,
**dadurch gekennzeichnet,**
**dass** die Steuereinrichtung (18) eine Abweichung des bei einer bestimmten Frequenz gemessenen Ist-Phasenversatzes an den Messstellen (M1, M2) von dem in der Speichereinrichtung (30) gespeicherten Soll-Phasenversatz an den Messstellen (M1, M2) erfasst und die Frequenz des bezüglich der Phase nachlaufenden Signalgenerators (SO1; SO2) während des Korrekturzeitintervalls (T_{corr}) erhöht und/oder die Frequenz des bezüglich der Phase vorlaufenden Signalgenerators (SO1; SO2) während des Korrekturzeitintervalls (T_{corr}) erniedrigt, wenn der Ist-Phasenversatz größer als der Soll-Phasenversatz ist bzw. die Frequenz des bezüglich der Phase nachlaufenden Signalgenerators (SO1; SO2) während des Korrekturzeitintervalls (T_{corr}) erniedrigt und/oder die Frequenz des bezüglich der Phase vorlaufenden Signalgenerators (SO1; SO2) während des Korrekturzeitintervalls (T_{corr}) erhöht, wenn der Ist-Phasenversatz kleiner als der Soll-Phasenversatz ist.

4. Messgerät nach Anspruch 2 oder 3,
**dadurch gekennzeichnet,**
**dass** das Messgerät ein Mehrtor-Netzwerkanalysator mit mindestens drei Toren (T1,T2,T3) ist und zwischen einem ersten Tor (T1) und einem zweiten Tor (T2) ein differentielles Anregungssignal erzeugt wird, wobei zwischen den Anregungssignalen dieser Tore (T1,T2) ein Soll-Phasenversatz von 180° an den Referenzstellen (R1, R2) besteht.

5. Messgerät nach Anspruch 4,
**dadurch gekennzeichnet,**
**dass** zur Erstellung der Tabelle die Referenzstellen (R1, R2) des ersten Tors (T1) und des zweiten Tore (T2) über einen Signalkombinierer (31) mit dem dritten Tor (T3) verbunden sind, wobei die Steuereinheit (18) das Erreichen des Soll-Phasenversatzes von 180° dadurch detektiert, dass ein Auslöschen oder ein Minimum der Amplitude des am dritten Tor (T3) gemessenen Signals vorliegt.

6. Messgerät nach Anspruch 5,
**dadurch gekennzeichnet,**
**dass** die Steuereinheit (18) zusätzlich die Amplituden der Anregungssignale an dem ersten Tor (T1) und/oder an dem zweiten Tor (T2) durch Ansteuern von Dämpfungsgliedern (29₁, 29₂) so einstellt, dass ein Auslöschen des am dritten Tor (T3) detektierten Signals vorliegt.

7. Verfahren zum Betreiben eines Messgeräts (1), insbesondere eines vektoriellen Netzwerkanalysators, der über zumindest zwei Tore (T1, T2) mit einem Messobjekt (DUT) verbindbar ist, mit mehreren jeweils einem Tor (T1; T2) zugeordneten Anregungseinheiten (2₁; 2₂), wobei jede Anregungseinheit (2₁; 2₂) einen Signalgenerator (SO1; SO2) aufweist, mit welchem das zugeordnete Tor (T1; T2) mit einem Anregungssignal beaufschlagbar ist,
mit folgenden Verfahrensschritten:
- Messen des Ist-Phasenversatzes zwischen den an den Toren (T1; T2) ausgegebenen Anregungssignalen an Messstellen (M1, M2) und
- Verändern der Frequenz (f_{SO1}; f_{SO2}) zumindest eines der beiden Signalgeneratoren (SO1; SO2) während eines Korrekturzeitintervalls (T_{corr}) so, dass ein vorgegebener Soll-Phasenversatz an Referenzstellen (R1, R2) zwischen den an den Toren (T1, T2) ausgegebenen Anregungssignalen erzielt wird,
**dadurch gekennzeichnet dass**
ein Bezug zwischen einer Soll-Phasendifferenz (Δ*φ*) an den Referenzstellen (R1, R2) und einer zugehörigen Soll-Phasendifferenz (Δ*ϕ*) an den Messstellen (M1, M2) durch Kalibrierung ermittelt wird,
wobei die Kalibrierung für jeden Frequenzpunkt, der durch das Messgerät (1) ansteuerbar ist, durchgeführt wird, und wobei die Referenzstellen (R1, R2) über Messkabel (3₁, 3₂) mit Toren des Messgeräts (1) verbunden sind.

8. Verfahren nach Anspruch 7,
**gekennzeichnet durch**
Speichern einer Tabelle mit jeweils einem Soll-Phasenversatz an den Messstellen (M1, M2) in Bezug zu einem Soll-Phasenversatz an den Referenzstellen (R1, R2) zwischen den an den Toren (T1, T2) ausgegebenen Anregungssignalen jeweils für mehrere Frequenzen.

9. Verfahren nach Anspruch 8,
**gekennzeichnet durch**
Erfassen einer Abweichung des bei einer bestimmten Frequenz gemessenen Ist-Phasenversatzes an den Messstellen (M1, M2) von dem gespeicherten Soll-Phasenversatz an den Messstellen (M1 und M2) und
Erhöhen der Frequenz des bezüglich der Phase nachlaufenden Signalgenerators (SO1; SO2) während des Korrekturzeitintervalls (T_{corr}) und/oder Erniedrigen der Frequenz des bezüglich der Phase vorlaufenden Signalgenerators (SO2; SO1) während des Korrekturzeitintervalls (T_{corr}), wenn der Ist-Phasenversatz größer als der Soll-Phasenversatz ist bzw. Erniedrigen der Frequenz des bezüglich der Phase nachlaufenden Signalgenerators (SO1; SO2) während des Korrekturzeitintervalls (T_{corr}) und/oder Erhöhen der Frequenz des bezüglich der Phase vorlaufenden Signalgenerators (SO2; SO1) während des Korrekturzeitintervalls (T_{corr}), wenn der Ist-Phasenversatz kleiner als der Soll-Phasenversatz ist.

10. Verfahren nach Anspruch 8 oder 9,
**dadurch gekennzeichnet,**
**dass** das Messgerät ein Mehrtor-Netzwerkanalysator mit mindestens drei Toren (T1,T2,T3) ist und zwischen einem ersten Tor (T1) und einem zweiten Tor (T2) ein differentielles Anregungssignal erzeugt wird, wobei zwischen den Anregungssignalen dieser Tore (T1,T2) eine Soll-Phasenversatz von 180° an den Referenzstellen (R1, R2) besteht.

11. Verfahren nach Anspruch 10,
**gekennzeichnet durch**
Verbinden der Referenzstellen (R1, R2) des ersten Tors (T1) und des zweiten Tors (T2) über einen Signalkombinierer (31) mit dem dritten Tor (T3), und Detektieren des Erreichens des Soll-Phasenversatzes von 180° **dadurch** , dass ein Auslöschen oder ein Minimum der Amplitude des am dritten Tor (T3) detektierten Signals vorliegt.

12. Verfahren nach Anspruch 11,
**gekennzeichnet durch**
Einstellen der Amplitude der Anregungssignale an dem ersten Tor (T1) und/oder an dem zweiten Tor (T2) so, dass ein Auslöschen des am dritten Tor (T3) detektierten Signals vorliegt.

## Claims

1. Measuring device (1), in particular a vectorial network analyser, which can be connected via at least two ports (T1, T2) to a device under test (DUT), comprising:
several excitation units (2₁; 2₂) each assigned to a port (T1; T2), wherein each excitation unit (2₁; 2₂) has a signal generator (SO1; S02), with which the assigned port (T1; T2) can be supplied with an excitation signal;
a phase-measuring device (9₁, 9₂, 17) for measuring, at measuring positions (M1, M2), the actual phase offset between the excitation signals output at the ports (T1; T2); and
a control device (18), which varies the frequency (f_{SO1}; f_{SO2}) of at least one of the two signal generators (SO1; S02) during a correction interval (T_{corr}) in such a manner that a specified set phase offset is achieved at reference positions (R1, R2) between the excitation signals output at the ports (T1, T2),
**characterised in that**
a relationship between a set phase difference (ΔΦ) at the reference positions (R1, R2) and an associated set phase difference (Δϕ) at the measuring positions (M1, M2) is determined by means of calibration, wherein the calibration is carried out for each frequency point which can be controlled by the measuring device (1), and wherein the reference positions (R1, R2) are connected to ports of the measuring device (1) via measuring cables (3₁, 3₂).

2. Measuring device according to claim 1,
**characterised by**
a memory device (30), in which a table is stored with one set phase offset at each of the measuring positions related to a set phase offset at the reference positions (R1, R2) between the excitation signals output at the ports (T1, T2) for each of several frequencies.

3. Measuring device according to claim 2,
**characterised in that**
the control device (18) registers a deviation of the actual phase offset measured at a given frequency at the measuring positions (M1, M2) from the set phase offset at the measuring positions (M1, M2) stored in the memory device (30) and increases the frequency of the signal generator (SO1; S02) lagging in phase during the correction interval (T_{corr}) and/or reduces the frequency of the signal generator (SO1; S02) leading in phase during the correction interval (T_{corr}), if the actual phase offset is greater than the set phase offset, or respectively reduces the frequency of the signal generator (SO1; S02) lagging in phase during the correction interval (T_{corr}) and/or increases the frequency of the signal generator (SO1; S02) leading in phase during the correction interval (T_{corr}), if the actual phase offset is less than the set phase offset.

4. Measuring device according to claim 2 or 3,
**characterised in that**
the measuring device is a multi-port network analyser with at least three ports (T1, T2, T3), and a differential excitation signal is generated between a first port (T1) and a second port (T2), wherein a set phase offset of 180° at the reference positions (R1, R2) exists between the excitation signals of these ports (T1, T2).

5. Measuring device according to claim 4,
**characterised in that,**
in order to provide the table, the reference positions (R1, R2) of the first port (T1) and of the second port (T2) are connected via a signal combiner (31) to the third port (T3), wherein the control unit (18) detects the reaching of the set phase offset of 180° from the presence of an elimination or a minimum of the amplitude of the signal measured at the third port (T3).

6. Measuring device according to claim 5,
**characterised in that**
the control unit (18) additionally sets the amplitudes of the excitation signals at the first port (T1) and/or at the second port (T2) by controlling attenuation elements (29₁, 29₂) in such a manner that an elimination of the signal detected at the third port (T3) is present.

7. Method for operating a measuring device (1), in particular a vectorial network analyser, which can be connected via at least two ports (T1, T2) to a device under test (DUT), comprising several excitation units (2₁; 2₂) each assigned to a port (T1; T2), wherein each excitation unit (2₁; 2₂) has a signal generator (SO1; S02), with which the assigned port (T1; T2) can be supplied with an excitation signal, comprising the following procedural stages:
- measurement, at measuring positions (M1, M2), of the actual phase offset between the excitation signals output at the ports (T1; T2), and
- variation of the frequency (f_{SO1}; f_{SO2}) of at least one of the two signal generators (SO1; S02) during a correction interval (T_{corr}) in such a manner that a specified set phase offset is achieved at reference positions (R1, R2) between the excitation signals output at the ports (T1, T2),
**characterised in that**
a relationship between a set phase difference (ΔΦ) at the reference positions (R1, R2) and an associated set phase difference (Δϕ) at the measuring positions (M1, M2) is determined by means of calibration, wherein the calibration is carried out for each frequency point which can be controlled by the measuring device (1), and wherein the reference positions (R1, R2) are connected to ports of the measuring device (1) via measuring cables (3₁, 3₂).

8. Method according to claim 7,
**characterised by**
the storage of a table with one set phase offset at each of the measuring positions (M1, M2) related to a set phase offset at the reference positions (R1, R2) between the excitation signals output at the ports (T1, T2) for each of several frequencies.

9. Method according to claim 8,
**characterised by**
a registration of a deviation of the actual phase offset measured at a given frequency at the measuring positions (M1 and M2) from the stored set phase offset at the measuring positions (M1, M2) and
an increase of the frequency of the signal generator (SO1; S02) lagging in phase during the correction interval (T_{corr}) and/or a reduction of the frequency of the signal generator (SO2; SO1) leading in phase during the correction time interval (T_{corr}), if the actual phase offset is greater than the set phase offset, or respectively a reduction of the frequency of the signal generator (SO1; S02) lagging in phase during the correction interval (T_{corr}) and/or an increase of the frequency of the signal generator (SO2; SO1) leading in phase during the correction interval (T_{corr}), if the actual phase offset is less than the set phase offset.

10. Method according to claim 8 or 9,
**characterised in that**
the measuring device is a multi-port network analyser with at least three ports (T1, T2, T3), and a differential excitation signal is generated between a first port (T1) and a second port (T2), wherein a set phase offset of 180° at the reference positions (R1, R2) exists between the excitation signals of these ports (T1, T2).

11. Method according to claim 10,
**characterised by**
a connection of the reference positions (R1, R2) of the first port (T1) and of the second port (T2) via a signal combiner (31) to the third port (T3), and
a detection of the reaching of the set phase offset of 180° from the presence of an elimination or a minimum of the amplitude of the signal detected at the third port (T3).

12. Method according to claim 11,
**characterised by**
a setting of the amplitude of the excitation signals at the first port (T1) and/or at the second port (T2) in such a manner that an elimination of the signal detected at the third port (T3) is present.

## Revendications

1. Appareil de mesure (1), en particulier analyseur de réseau vectoriel, qui peut être relié à un objet à mesurer (DUT) par l'intermédiaire d'au moins deux portes (T1, T2), comprenant
plusieurs unités d'excitation (2₁ ; 2₂) respectivement associées à une porte (T1, T2), dans lequel chaque unité d'excitation (2₁ ; 2₂) présente un générateur de signaux (SO1 ; S02) au moyen duquel la porte (T1 ; T2) associée peut être soumise à l'effet d'un signal d'excitation,
un dispositif de mesure de phase (9₁, 9₂, 17) destiné à mesurer le déphasage réel entre les signaux d'excitation émis au niveau des portes (T1 ; T2) aux points de mesure (M1, M2) et un dispositif de commande (18), lequel modifie la fréquence (f_{S01} ; f_{S02}) d'au moins un des deux générateurs de signaux (S01 ; S02) pendant un intervalle de temps de correction (T_{corr}), de sorte qu'un déphasage théorique prédéfini aux points de référence (R1, R2) entre les signaux d'excitation émis au niveau des portes (T1, T2) est obtenu,
**caractérisé**
**en ce qu'**un rapport entre une différence de phase théorique (Δ*φ*) aux points de référence (R1, R2) et une différence de phase théorique (Δ*φ*) associée aux points de mesure (M1, M2) est déterminé par étalonnage,
dans lequel l'étalonnage est mis en oeuvre pour chaque point de fréquence qui peut être commandé par l'appareil de mesure (1), et
dans lequel les points de référence (R1, R2) sont reliés aux portes de l'appareil de mesure (1) par l'intermédiaire de câbles de mesure (3₁, 3₂).

2. Appareil de mesure selon la revendication 1,
**caractérisé par**
un dispositif mémoire (30), dans lequel une table comprenant respectivement un déphasage théorique aux points de mesure par rapport à un déphasage théorique aux points de référence (R1, R2) entre les signaux d'excitation émis au niveau des portes (T1, T2) respectivement pour plusieurs fréquences est mise en mémoire.

3. Appareil de mesure selon la revendication 2,
**caractérisé**
**en ce que** le dispositif de commande (18) détecte un écart entre le déphasage réel mesuré à une fréquence définie aux points de mesure (M1, M2) et le déphasage théorique mis en mémoire dans le dispositif mémoire (30) aux points de mesure (M1, M2) et la fréquence du générateur de signaux (SO1 ; SO2) en retard par rapport à la phase est augmentée pendant l'intervalle de temps de correction (T_{corr}) et/ou la fréquence du générateur de signaux (SO1 ; SO2) en avance par rapport à la phase est abaissée pendant l'intervalle de temps de correction (T_{corr}), lorsque le déphasage réel est supérieur au déphasage théorique ou la fréquence du générateur de signaux (SO1 ; SO2) en retard par rapport à la phase est abaissée pendant l'intervalle de temps de correction (T_{corr}) et/ou la fréquence du générateur de signaux (SO1 ; S02) en avance par rapport à la phase est augmentée pendant l'intervalle de temps de correction (T_{corr}), lorsque le déphasage réel est inférieur au déphasage théorique.

4. Appareil de mesure selon la revendication 2 ou 3,
**caractérisé**
**en ce que** l'appareil de mesure est un analyseur de réseau vectoriel à plusieurs portes comprenant au moins trois portes (T1, T2, T3) et un signal d'excitation différentiel est généré entre une première porte (T1) et une deuxième porte (T2), dans lequel un déphasage théorique de 180° aux points de référence (R1, R2) est présent entre les signaux d'excitation de ces portes (T1, T2).

5. Appareil de mesure selon la revendication 4,
**caractérisé**
**en ce que**, pour l'élaboration de la table, les points de référence (R1, R2) de la première porte (T1) et de la deuxième porte (T2) sont reliés à la troisième porte (T3) par un combineur de signaux (31), dans lequel l'unité de commande (18) détecte que le déphasage théorique de 180° est atteint par le fait qu'un effacement ou un minimum de l'amplitude du signal mesuré au niveau de la troisième porte (T3) est présent.

6. Appareil de mesure selon la revendication 5,
**caractérisé**
**en ce que** l'unité de commande (18) règle en outre les amplitudes des signaux d'excitation au niveau de la première porte (T1) et/ou au niveau de la deuxième porte (T2) en commandant des organes d'amortissement (29₁, 29₂), de sorte qu'un effacement du signal détecté au niveau de la troisième porte (T3) est présent.

7. Procédé pour le fonctionnement d'un appareil de mesure (1), en particulier d'un analyseur de réseau vectoriel, qui peut être relié à un objet à mesurer (DUT) par l'intermédiaire d'au moins deux portes (T1, T2), comprenant plusieurs unités d'excitation (2₁ ; 2₂) respectivement associées à une porte (T1, T2), dans lequel chaque unité d'excitation (2₁ ; 2₂) présente un générateur de signaux (SO1 ; S02) au moyen duquel la porte (T1 ; T2) associée peut être soumise à l'effet d'un signal d'excitation,
comprenant les étapes de procédé suivantes :
- la mesure du déphasage réel entre les signaux d'excitation émis au niveau des portes (T1 ; T2) aux points de mesure (M1, M2) et
- la modification de la fréquence (f_{S01} ;f_{S02}) d'au moins un des deux générateurs de signaux (SO1 ; S02) pendant un intervalle de temps de correction (T_{corr}), de sorte qu'un déphasage théorique prédéfini aux points de référence (R1, R2) entre les signaux d'excitation émis au niveau des portes (T1, T2) est obtenu,
**caractérisé**
**en ce qu'**un rapport entre une différence de phase théorique (Δ*φ*) aux points de référence (R1, R2) et une différence de phase théorique (Δ*φ*) associée aux points de mesure (M1, M2) est déterminé par étalonnage,
dans lequel l'étalonnage est mis en oeuvre pour chaque point de fréquence qui peut être commandé par l'appareil de mesure (1), et
dans lequel les points de référence (R1, R2) sont reliés aux portes de l'appareil de mesure (1) par l'intermédiaire de câbles de mesure (3₁, 3₂).

8. Procédé selon la revendication 7,
**caractérisé par**
la mise en mémoire d'une table comprenant respectivement un déphasage théorique aux points de mesure (M1, M2) par rapport à un déphasage théorique aux points de référence (R1, R2) entre les signaux d'excitation émis au niveau des portes (T1, T2) respectivement pour plusieurs fréquences.

9. Procédé selon la revendication 8,
**caractérisé par**
la détection d'un écart entre le déphasage réel mesuré à une fréquence définie aux points de mesure (M1, M2) et le déphasage théorique mis en mémoire aux points de mesure (M1 et M2) et
l'augmentation de la fréquence du générateur de signaux (SO1 ; S02) en retard par rapport à la phase pendant l'intervalle de temps de correction (T_{corr}) et/ou l'abaissement de la fréquence du générateur de signaux (SO1 ; S02) en avance par rapport à la phase pendant l'intervalle de temps de correction (T_{corr}), lorsque le déphasage réel est supérieur au déphasage théorique ou l'abaissement de la fréquence du générateur de signaux (SO1 ; S02) en retard par rapport à la phase pendant l'intervalle de temps de correction (T_{corr}) et/ou l'augmentation de la fréquence du générateur de signaux (S02 ; SO1) en avance par rapport à la phase pendant l'intervalle de temps de correction (T_{corr}), lorsque le déphasage réel est inférieur au déphasage théorique.

10. Procédé selon la revendication 8 ou 9,
**caractérisé**
**en ce que** l'appareil de mesure est un analyseur de réseau vectoriel à plusieurs portes comprenant au moins trois portes (T1, T2, T3) et un signal d'excitation différentiel est généré entre une première porte (T1) et une deuxième porte (T2), dans lequel un déphasage théorique de 180° aux points de référence (R1, R2) est présent entre les signaux d'excitation de ces portes (T1, T2).

11. Procédé selon la revendication 10,
**caractérisé par**
la liaison des points de référence (R1, R2) de la première porte (T1) et de la deuxième porte (T2) à la troisième porte (T3) par l'intermédiaire d'un combineur de signaux (31), et
la détection qu'un déphasage théorique de 180° est atteint par le fait qu'un effacement ou un minimum de l'amplitude du signal détecté au niveau de la troisième porte (T3) est présent.

12. Procédé selon la revendication 11,
**caractérisé par**
le réglage de l'amplitude des signaux d'excitation au niveau de la première porte (T1) et/ou au niveau de la deuxième porte (T2), de sorte qu'un effacement du signal détecté au niveau de la troisième porte (T3) est présent.
